# EUROPÄISCHE PATENTSCHRIFT

(11) **EP 3 300 192 B1**
(45) Veröffentlichungstag und Bekanntmachung des Hinweises auf die Patenterteilung: **28.04.2021**
(21) Anmeldenummer: 17178070.3
(22) Anmeldetag: 27.06.2017
(51) Int. Cl.: H01S 5/00, F21Y 115/30, F21S 41/16, F21S 41/675

(54) **BELEUCHTUNGSVORRICHTUNG**
ILLUMINATION DEVICE
DISPOSITIF D'ÉCLAIRAGE

(30) Priorität: 05.08.2016 DE 102016214513
(43) Veröffentlichungstag der Anmeldung: 28.03.2018
(73) Patentinhaber: OSRAM Beteiligungsverwaltung GmbH, 82031 Grünwald (DE)
(72) Erfinder: Woisetschlaeger, Oliver, 89567 Sontheim (DE); Buchmann, Frank, 07745 Jena (DE)
(74) Vertreter: OSRAM GmbH - GC IP

(56) Entgegenhaltungen:
- WO-A1-2014/121315
- WO-A1-2017/008942
- US-A- 3 396 344
- US-A1- 2013 258 689

## Beschreibung

### Technisches Gebiet

Die Erfindung betrifft eine Beleuchtungseinrichtung mit einer Halbleiterlasereinrichtung, die ausgebildet ist, mehrere Laserlichtbündel zu erzeugen, und mit mindestens einem Lichtwellenlängenkonversionselement, das ausgebildet ist, Licht der Laserlichtbündel anteilig in Licht anderer Wellenlänge zu konvertieren, so dass vom mindestens einen Lichtwellenlängenkonversionselement Licht abgestrahlt wird, das eine Mischung aus nicht-wellenlängenkonvertiertem Laserlicht und wellenlängenkonvertiertem Licht ist. Vorzugsweise sind die Halbleiterlasereinrichtung und das mindestens eine Lichtwellenlängenkonversionselement derart aufeinander abgestimmt, dass die Mischung aus nicht-wellenlängenkonvertiertem Laserlicht und wellenlängenkonvertiertem Licht weißes Licht ergibt. Die Beleuchtungseinrichtung dient beispielsweise als Lichtquelle für einen Kraftfahrzeugscheinwerfer.

### Stand der Technik

Bei Beleuchtungseinrichtungen, die mit einer Halbleiterlasereinrichtung ausgestattet sind, können die von der Halbleiterlasereinrichtung erzeugten Laserlichtbündel eine richtungsabhängige Aufweitung bzw. Divergenz besitzen, die Probleme bei der Erzeugung bzw. Abbildung einer gewünschten Lichtverteilung verursacht. Die richtungsabhängige Aufweitung bzw. Divergenz eines Laserlichtbündels wird mit Hilfe der Begriffe Slow-Axis und Fast-Axis erfasst. In einer Ebene senkrecht zur Ausbreitungsrichtung des Laserlichtbündels bezeichnet der Begriff Slow-Axis die Richtung minimaler Divergenz des Laserlichtbündels und der Begriff Fast-Axis die Richtung maximaler Divergenz des Laserlichtbündels. Die Form und Größe eines Leuchtflecks bzw. Laserspots, den ein Laserlichtbündel auf der Oberfläche eines Schirms oder eines Lichtwellenlängenkonversionselements erzeugt, ist daher abhängig von dem ursprünglichen Profil des Laserlichtbündels unmittelbar nach dem Verlassen der Halbleiterlasereinrichtung und von der Länge des Weges, den das Laserlichtbündel zwischen der Halbleiterlasereinrichtung und dem Schirm bzw. einer Lichtwellenlängenkonversionseinrichtung zurückgelegt hat

WO2014/121315 A1 offenbart eine Beleuchtungsvorrichtung gemäß dem Oberbegriff des Anspruchs 1.

### Darstellung der Erfindung

Es ist Aufgabe der vorliegenden Erfindung, eine Beleuchtungseinrichtung mit einer mehrere Laserlichtbündl erzeugenden Halbleiterlasereinrichtung und mit mindestens einem Lichtwellenlängenkonversionselement bereitzustellen, die eine verbesserte Justierung und/oder Ausrichtung und/oder Formung der Laserlichtbündel auf einer Oberfläche des mindestens einen Lichtwellenlängenkonversionselements ermöglicht.

Diese Aufgabe wird durch eine Beleuchtungseinrichtung mit den Merkmalen aus dem Anspruch 1 gelöst. Besonders vorteilhafte Ausgestaltungen der Erfindung sind in den abhängigen Ansprüchen ausgeführt.

Die erfindungsgemäße Beleuchtungseinrichtung besitzt eine Halbleiterlasereinrichtung, die zum Erzeugen mehrerer Laserlichtbündel ausgebildet ist, und mindestens ein Lichtwellenlängenkonversionselement, das ausgebildet ist, Laserlicht zumindest anteilig in Licht anderer Wellenlänge zu konvertieren, sowie eine Optik, die ausgebildet ist, die Laserlichtbündel auf eine Oberfläche des mindestens einen Lichtwellenlängenkonversionselements zu lenken. Die Optik weist mindestens ein um mindestens eine Achse schwenkbares Spiegelelement auf, das ausgebildet ist, die Laserlichtbündel über zumindest einen Oberflächenabschnitt der Oberfläche des mindestens einen Lichtwellenlängenkonversionselements zu führen. Außerdem umfasst die Optik Mittel zur Justierung einer Divergenz bzw. Aufweitung der Laserlichtbündel entlang einer Slow-Axis oder einer Fast-Axis oder Mittel zur Justierung einer Divergenz bzw. Aufweitung der Laserlichtbündel entlang einer Slow-Axis und einer Fast-Axis der Laserlichtbündel auf dem vorgenannten Oberflächenabschnitt der Oberfläche des mindestens einen Lichtwellenlängenkonversionselements.

Dadurch kann eine präzise Ausrichtung der Laserlichtbündel relativ zueinander auf der Oberfläche des mindestens einen Lichtwellenlängenkonversionselements gewährleistet werden. Insbesondere können dadurch die Laserspotgröße und die Laserspotform sowie die Anordnung jedes Laserlichtbündels auf dem Oberflächenabschnitt der Oberfläche des mindestens einen Lichtwellenlängenkonversionselements justiert bzw. eingestellt werden.

Vorteilhafterweise umfassen die obengenannten Mittel der Optik der erfindungsgemäßen Beleuchtungseinrichtung mindestens eine erste Zylinderlinse zur Fokussierung der Laserlichtbündel entlang ihrer Slow-Axis. Die mindestens eine erste Zylinderlinse ermöglicht eine Justierung der Laserspots der Laserlichtbündel auf der Oberfläche des mindestens einen Lichtwellenlängenkonversionselements in Richtung ihrer Slow-Axis.

Vorzugsweise sind die Laserlichtbündel derart angeordnet, dass ihre Lichtausbreitungsrichtungen, ihre Slow-Axis und ihre Fast-Axis parallel zueinander verlaufen. Dadurch genügt eine gemeinsame erste Zylinderlinse zur Fokussierung bzw. Justierung der Slow-Axis aller Laserlichtbündel auf der Oberfläche des mindestens einen Lichtwellenlängenkonversionselements.

Die mindestens eine erste Zylinderlinse ist vorzugsweise als plan-konvexe Zylinderlinse ausgebildet, deren konvexe Krümmung in Richtung der Slow-Axis der Laserlichtbündel verläuft.

Vorteilhafterweise sind die Optik und die Halbleiterlasereinrichtung der erfindungsgemäßen Beleuchtungseinrichtung derart ausgebildet, dass die Laserlichtbündel jeweils parallel zu einer Abtastrichtung über einen Oberflächenabschnitt der Oberfläche des mindestens einen Lichtwellenlängenkonversionselements geführt werden. Dadurch kann ein Oberflächenabschnitt oder die gesamte Oberfläche des mindestens einen Lichtwellenlängenkonversionselements zeilenweise oder spaltenweise mit Laserlicht abgetastet werden und eine gewünschte Lichtverteilung generiert werden. Insbesondere können die Laserlichtbündel mittels des mindestens einen Spiegelelements simultan über die Oberfläche des mindestens einen Lichtwellenlängenkonversionselements geführt werden und dadurch mehrere Zeilen oder Spalten des Oberflächenabschnitts gleichzeitig mit Laserlicht abgetastet werden. Außerdem kann während des zeilenweisen oder spaltenweisen Abtastens der Oberfläche des mindestens einen Lichtwellenlängenkonversionselements durch zeitweiliges Ausschalten oder Dimmen oder betriebsstrommäßiges Überhöhen einzelner oder aller Laserlichtquellen der Halbleiterlasereinrichtung eine Lichtverteilung auf der Oberfläche des mindestens einen Lichtwellenlängenkonversionselements variiert werden.

Die Optik und die Halbleiterlasereinrichtung der erfindungsgemäßen Beleuchtungseinrichtung sind vorzugsweise derart ausgebildet, dass die Slow-Axis der Laserlichtbündel auf dem Oberflächenabschnitt des mindestens einen Lichtwellenlängenkonversionselements jeweils senkrecht zur Abtastrichtung angeordnet ist. Dadurch sind eine genaue Justierung der Laserspotgröße senkrecht zur Abtastrichtung und eine genaue Justierung des Abstand zwischen den Laserspots der Laserlichtbündel auf der Oberfläche des mindestens einen Lichtwellenlängenkonversionselements und insbesondere auch eine Minimierung des Abstands zwischen den Laserspots senkrecht zur Abtastrichtung möglich.

Erfindungsgemäß umfassen die oben genannten Mittel zur Justierung einer Divergenz bzw. Aufweitung der Laserlichtbündel entlang einer Slow-Axis oder bzw. und einer Fast-Axis der Laserlichtbündel mindestens ein asphärisches optisches Element zur Fokussierung der Laserlichtbündel entlang einer Fast-Axis der Laserlichtbündel. Dadurch wird eine Fokussierung der Laserlichtbündel entlang der Fast-Axis der Laserlichtbündel auf der Oberfläche des mindestens einen Lichtwellenlängenkonversionselements ermöglicht. Das mindestens eine asphärische optische Element hat den weiteren Vorteil, dass es zusätzlich auch fokussierend auf die Laserlichtbündel entlang ihrer Slow-Axis wirkt. Vorzugsweise ist für jedes Laserlichtbündel ein separates asphärisches Element, beispielsweise eine asphärische optische Linse, vorgesehen, um die Aufweitung jedes Laserlichtbündels entlang seiner Fast-Axis separat auf einem Oberflächenabschnitt der Oberfläche des mindestens einen Lichtwellenlängenkonversionselements justieren zu können. Insbesondere ist es dadurch auch möglich, die Laserspotgrößen der Laserlichtbündel auf der Oberfläche des mindestens einen Lichtwellenlängenkonversionselements trotz unterschiedlicher Weglänge und unterschiedlicher Divergenz bzw. Aufweitung der Laserlichtbündel einander anzugleichen.

Die Optik und die Halbleiterlasereinrichtung der erfindungsgemäßen Beleuchtungseinrichtung sind vorzugsweise derart ausgebildet, dass die Fast-Axis der Laserlichtbündel auf dem Oberflächenabschnitt des mindestens einen Lichtwellenlängenkonversionselements jeweils parallel zur Abtastrichtung angeordnet ist.

Das mindestens eine asphärische optische Element ist im Lichtstrahlengang der Laserlichtbündel vorzugsweise vor der mindestens einen ersten Zylinderlinse und besonders bevorzugt unmittelbar nach der Halbleiterlasereinrichtung angeordnet, um die Divergenz der Laserlichtbündel vor dem Auftreffen auf andere Komponenten der Optik der erfindungsgemäßen Beleuchtungseinrichtung, insbesondere vor dem Auftreffen auf das mindestens eine, um mindestens eine Achse schwenkbare Spiegelelement, zu reduzieren.

Erfindungsgemäß umfassen die obengenannten Mittel zur Justierung einer Divergenz bzw. Aufweitung der Laserlichtbündel entlang einer Slow-Axis oder bzw. und einer Fast-Axis der Laserlichtbündel mindestens eine zweite Zylinderlinse, die zwecks Aufweitung zumindest eines Laserlichtbündels entlang der Slow-Axis im Lichtstrahlengang mindestens eines Laserlichtbündels angeordnet ist. Die mindestens eine zweite Zylinderlinse hat den Vorteil, dass die Divergenz des mindestens einen Laserlichtbündels und damit die Laserspotabmessung in Richtung seiner Slow-Axis, auf einem Oberflächenabschnitt der Oberfläche des mindestens einen Lichtwellenlängenkonversionselements unabhängig von den anderen Laserlichtbündeln justiert werden kann. Vorzugsweise ist für jedes Laserlichtbündel eine zweite Zylinderlinse vorgesehen, um die Divergenz bzw. Aufweitung jedes einzelnen Laserlichtbündels entlang seiner Slow-Axis unabhängig von den anderen Laserlichtbündeln auf einem Oberflächenabschnitt der Oberfläche des mindestens einen Lichtwellenlängenkonversionselements justieren zu können. Beispielsweise ermöglichen die zweiten Zylinderlinsen eine Angleichung der Abmessungen der von den Laserlichtbündeln auf der Oberfläche des mindestens einen Lichtwellenlängenkonversionselements verursachten Laserspots in Richtung der Slow-Axis. Alternativ können mittels der zweiten Zylinderlinse aber auch Laserspots mit unterschiedlichen Abmessungen bzw. gegenseitigen Beabstandungen in Richtung der Slow-Axis erzeugt werden.

Die mindestens eine zweite Zylinderlinse ist erfindungsgemäß als plan-konkave Zylinderlinse ausgebildet, um eine Aufweitung der Laserlichtbündel entlang ihrer Slow-Axis zu erreichen. Dabei verläuft die konkave Krümmung der mindestens einen plan-konkaven Zylinderlinse in Richtung der Slow-Axis der Laserlichtbündel, so dass die Wirkung der plan-konkaven Zylinderlinsen auf die Divergenz bzw. Aufweitung der Laserlichtbündel entlang der Slow-Axis beschränkt ist und sich insbesondere nicht auf die Divergenz bzw. Aufweitung der Laserlichtbündel entlang der Fast-Axis erstreckt.

Besonders vorteilhaft ist die Kombination des mindestens einen asphärischen optischen Elements mit der mindestens einen ersten, plan-konvexen Zylinderlinse und der mindestens einen zweiten, plankonkaven Zylinderlinse.

Durch das Zusammenwirken des mindestens einen asphärischen optischen Elements mit der mindestens einen ersten und zweiten Zylinderlinse wird eine individuelle Justierung der Divergenz der Laserlichtbündel in Richtung ihrer Slow-Axis und ihrer Fast-Axis ermöglicht, so dass die von den Laserlichtbündeln auf einem Oberflächenabschnitt der Oberfläche des mindestens einen Lichtwellenlängenkonversionselements verursachten Laserspots entlang der Slow-Axis und entlang der Fast-Axis jeweils die gewünschten Abmessungen aufweisen.

Vorteilhafterweise ist die erfindungsgemäße Beleuchtungseinrichtung derart ausgebildet, dass die Ausbreitungsrichtung und die Slow-Axis sowie die Fast-Axis der von ihrer Halbleiterlasereinrichtung emittierten Laserlichtbündel jeweils parallel zueinander ausgerichtet sind. Dadurch kann mittels der Laserlichtbündel mit geringem Aufwand eine simultane zeilenweise oder spaltenweise Abtastung eines Oberflächenabschnitts der Oberfläche des mindestens einen Lichtwellenlängenkonversionselements realisiert werden.

Die Halbleiterlasereinrichtung der erfindungsgemäßen Beleuchtungseinrichtung weist vorteilhafterweise mehrere Laserdioden auf, die jeweils ausgebildet sind, während ihres Betriebs blaues Laserlicht zu erzeugen, und das mindestens eine Lichtwellenlängenkonversionselement der erfindungsgemäßen Beleuchtungseinrichtung ist vorzugsweise ausgebildet, blaues Laserlicht anteilig in Licht anderer Wellenlänge zu konvertieren, so dass von dem mindestens einen Lichtwellenlängenkonversionselement weißes Licht emittiert wird, das eine Mischung aus nicht-wellenlängenkonvertiertem blauem Laserlicht und am mindestens einen Lichtwellenlängenkonversionselement wellenlängenkonvertiertem Licht ist. Dadurch kann eine Lichtquelle für weißes Licht mit sehr hoher Leuchtdichte und Lichtintensität geschaffen werden, die insbesondere für Projektionsanwendungen, wie beispielsweise als Lichtquelle für einen Kraftfahrzeugscheinwerfer, vorteilhaft ist. Eine solche Beleuchtungseinrichtung kann auch als Laser-Activated-Remote-Phosphor (LARP) Beleuchtungseinrichtung bezeichnet werden.

Die erfindungsgemäße Beleuchtungseinrichtung ist vorzugsweise als Bestandteil eines Kraftfahrzeugscheinwerfers oder als Kraftfahrzeugscheinwerfer ausgebildet. Insbesondere können mit Hilfe der erfindungsgemäßen Beleuchtungseinrichtung Lichtverteilungen für einen Kraftfahrzeug-Frontscheinwerfer erzeugt werden. Im allgemeine kann ein Kraftfahrzeug ein Luftfahrzeug oder ein wassergebundenes Fahrzeug oder ein landgebundenes Fahrzeug sein. Das landgebundene Fahrzeug kann ein Kraftfahrzeug oder ein Schienenfahrzeug oder ein Fahrrad sein. Besonders bevorzugt ist die Verwendung des Fahrzeugscheinwerfers in einem Lastkraftwagen oder Personenkraftwagen oder Kraftrad. Weitere Anwendungen sind in Scheinwerfern und/oder Leuchten für Bühnen- und Effektbeleuchtung, Außenbeleuchtung, Raumbeleuchtung oder Allgemeinbeleuchtung

### Kurze Beschreibung der Zeichnungen

Nachstehend wird die Erfindung anhand eines bevorzugten Ausführungsbeispiels näher erläutert. Die Figuren zeigen:
- Fig. 1: eine Beleuchtungseinrichtung gemäß dem bevorzugten Ausführungsbeispiel der Erfindung in isometrischer, schematischer Darstellung,
- Fig. 2: eine Draufsicht auf wesentliche Komponenten der in Figur 1 abgebildeten Beleuchtungseinrichtung,
- Fig. 3: eine Seitenansicht der Halbleiterlasereinrichtung, der asphärischen Linsen und der plankonkaven Zylinderlinsen sowie des ersten Umlenkspiegels der in den Figuren 1 und 2 abgebildeten Beleuchtungseinrichtung in schematischer Darstellung,
- Fig. 4: einen Querschnitt durch den zweiten Umlenkspiegels, die plan-konvexe Zylinderlinse und den um eine Achse schwenkbaren Mikrospiegel der in den Figuren 1 und abgebildeten Beleuchtungseinrichtung in schematischer Darstellung,
- Fig. 5: einen Querschnitt durch den um eine Achse schwenkbaren Mikrospiegel und das Lichtwellenlängenkonversionselement der in den Figuren 1 und 2 abgebildeten Beleuchtungseinrichtung in schematischer Darstellung, und
- Fig. 6: eine Draufsicht auf die mit Laserlicht beleuchtete Oberfläche des Lichtwellenlängenkonversionselements der in den Figuren 1 und 2 abgebildeten Beleuchtungseinrichtung in schematischer Darstellung.

### Bevorzugte Ausführung der Erfindung

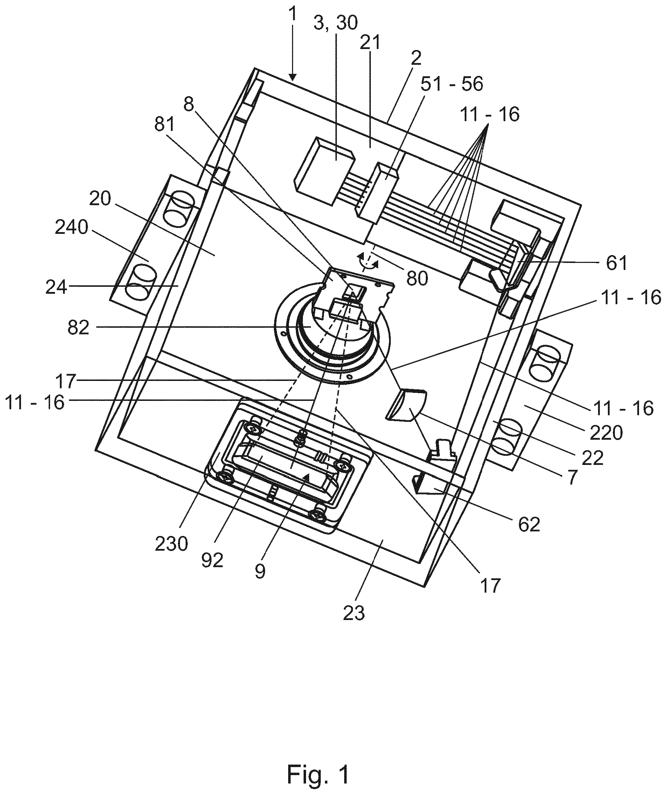

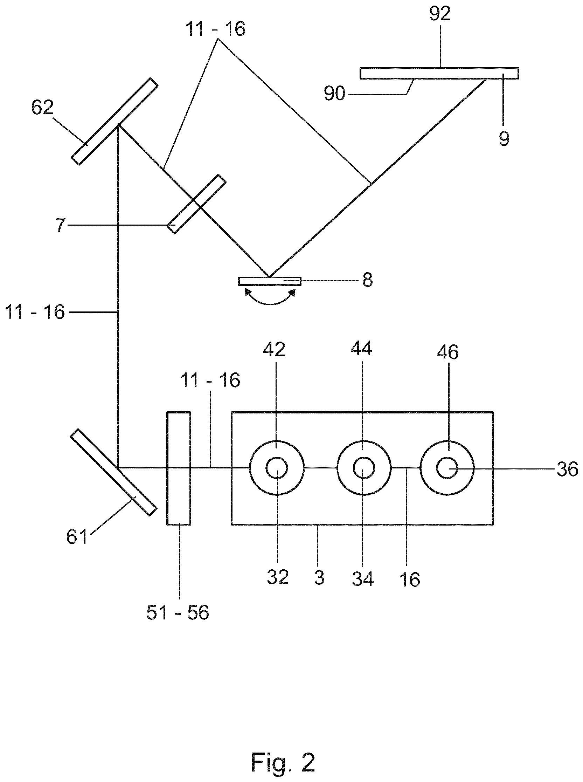

In den Figuren 1 und 2 ist schematisch eine Beleuchtungseinrichtung 1 gemäß dem bevorzugten Ausführungsbeispiel der Erfindung dargestellt. Diese Beleuchtungseinrichtung 1 ist als Bestandteil eines Kraftfahrzeugscheinwerfers ausgebildet, der zum Erzeugen von Abblendlicht oder Fernlicht oder von beiden vorgenannten Beleuchtungsfunktionen dient.

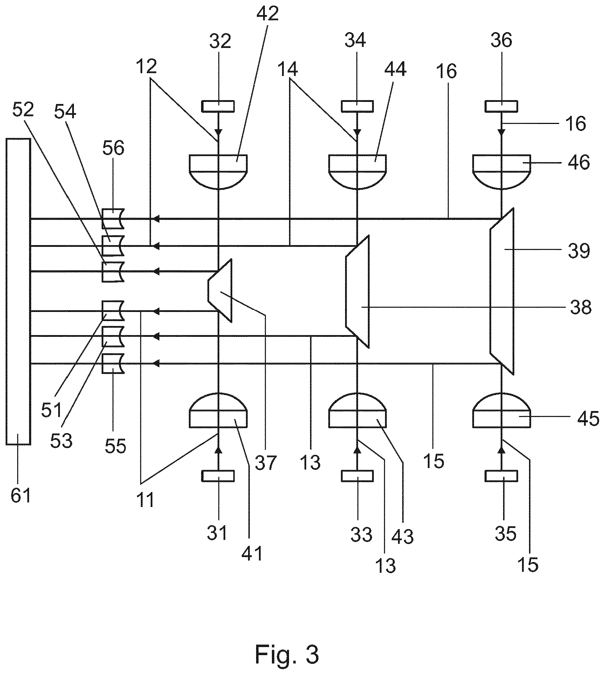

Die Beleuchtungseinrichtung 1 besitzt ein quaderförmiges Gehäuse 2, eine sechs Laserdioden 31 bis 36 aufweisende Halbleiterlasereinrichtung 30, drei Umlenkprismen 37 bis 39, sechs asphärische optische Linsen 41 bis 46, sechs plan-konkave optische Linsen 51 bis 56, zwei Umlenkspiegel 61, 62, eine plan-konvexe Zylinderlinse 7, einen um eine Achse 80 schwenkbaren Mikrospiegel 8 und ein Lichtwellenlängenkonversionselement 9. Die vorgenannten Komponenten der Beleuchtungseinrichtung 1 sind alle im Gehäuse 2 bzw. an einer Wand 21 bis 24 oder am Boden des Gehäuses 2 angeordnet. Die Halbleiterlasereinrichtung 30, die Umlenkprismen 37 bis 39 und die asphärischen Linsen 41 bis 46 werden auch als Beamcombiner 3 bezeichnet. In den Figuren 3 bis 5 ist der Laserlichtstrahlengang zwischen einigen Komponenten der Beleuchtungseinrichtung 1 schematisch dargestellt.

Das Gehäuse 2 der Beleuchtungseinrichtung 1 besteht aus Metall, vorzugsweise Aluminium, und besitzt einen Boden 20 und vier Seitenwände 21 bis 24 sowie einen Deckel, der in den Figuren 1 und 2 nicht gezeigt ist. Der Boden 20 und die Seitenwände 21 bis 24 dienen als Träger für die Komponenten der Beleuchtungseinrichtung 1. Die Außenabmessungen des quaderförmigen Gehäuses 2 betragen 100 mm mal 100 mm mal 50 mm.

Die Halbleiterlasereinrichtung 30 weist sechs gleichartige Laserdioden 31, 32, 33, 34, 35 und 36 auf, die während ihres Betriebs jeweils blaues Laserlicht mit einer Wellenlänge von 450 Nanometer emittieren. Die Laserdioden 31 bis 36 sind in zwei, parallel zum Boden 20 verlaufenden Zeilen und in drei senkrecht zum Boden 20 verlaufenden Spalten angeordnet. Die Laserdioden 31 bis 36 sind derart an einer ersten Seitenwand 21 des Gehäuses 2 befestigt, dass die von den Laserdioden 31 bis 36 abgestrahlten Laserlichtbündel 11 bis 16 jeweils senkrecht zum Boden 20 und parallel zur ersten Seitenwand 21 ausgerichtet sind. In Figur 3 ist die Anordnung und Ausrichtung der Laserdioden 31 bis 36 schematisch dargestellt. Die Laserdioden 31, 33, 35 sind in einer ersten, parallel zum Boden 20 des Gehäuses verlaufenden Zeile über dem Boden 20 angeordnet und derart ausgerichtet, dass die von ihnen abgestrahlten Laserlichtbündel 11, 13, 15 jeweils senkrecht zum Boden 20 verlaufen und zum Gehäusedeckel (nicht abgebildet) gerichtet sind, der dem Boden 20 gegenüberliegt. Die Laserdioden 32, 34, 36 sind in einer zweiten, parallel zum Boden 20 des Gehäuses verlaufenden Zeile angeordnet, die in größerer Höhe über dem Boden 20 verläuft als die erste Zeile. Die Laserdioden 32, 34, 36 sind derart ausgerichtet, dass die von ihnen abgestrahlten Laserlichtbündel 12, 14, 16 jeweils senkrecht zum Boden 20 verlaufen und zum Boden 20 gerichtet sind. Die Laserdioden 31, 32 und 33, 34 sowie 35, 36 sind jeweils übereinander an der ersten Seitenwand 21 des Gehäuses 2 fixiert.

Die von den Laserdioden 31 bis 36 abgestrahlten Laserlichtbündel 11 bis 16 weisen jeweils ein stark elliptisches Profil auf, so dass die Laserlichtbündel 11 bis 16 auf einem Schirm, der in einer Ebene senkrecht zu ihrer Lichtausbreitungsrichtung angeordnet ist, einen Laserleuchtfleck bzw. Laserspot mit elliptischer Kontur verursachen. Außerdem ist die Aufweitung bzw. Divergenz der Laserlichtbündel 11 bis 16 jeweils richtungsabhängig. Entlang ihrer Fast-Axis FA weisen die Laserlichtbündel 11 bis 16 jeweils die höchste Divergenz bzw. Aufweitung auf und entlang ihrer Slow-Axis SA weisen die Laserlichtbündel 11 bis 16 jeweils die geringste Divergenz bzw. Aufweitung auf. Fast-Axis und Slow-Axis sind senkrecht zueinander angeordnet und jeweils senkrecht zur Lichtausbreitungsrichtung der Laserlichtbündel orientiert. Die Aufweitung der Laserlichtbündel 11 bis 16 ist entlang ihrer Fast-Axis FA ungefähr viermal so groß wie ihre Aufweitung entlang ihrer Slow-Axis SA. Diese unterschiedliche Aufweitung der Laserlichtbündel 11 bis 16 entlang der Slow-Axis SA und Fast-Axis FA führt dazu, dass Form und Größe der vom Laserlichtbündeln 11 bis 16 verursachten Laserspots auf Schirmen, die in Ebenen senkrecht zur Lichtausbreitungsrichtung mit unterschiedlichen Abständen zu den Laserdiode 31 bis 36 aufgestellt sind, unterschiedlich sind. Beispielsweise beträgt der Divergenzwinkel entlang der Fast-Axis der Laserlichtbündel 11 bis 16 ca. 23° und entlang ihrer Slow-Axis nur ca. 6°.

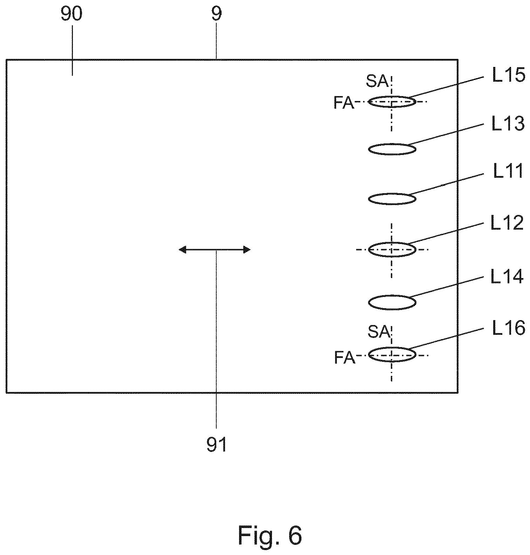

Die von den Laserlichtbündeln 11 bis 16 auf einem senkrecht zu ihrer Lichtausbreitungsrichtung angeordneten Schirm verursachten Laserspots besitzen daher eine elliptische Kontur, wobei die große Halbachse der elliptischen Kontur jeweils parallel zur Fast-Axis des jeweiligen Laserlichtbündels 11 bis 16 orientiert ist und die kleine Halbachse der elliptischen Kontur des Laserlichtbündels 11 bis 16 jeweils parallel zur Slow-Axis des jeweiligen Laserlichtbündels 11 bis 16 orientiert ist. In der Darstellung der Figur 6 ist dieser Sachverhalt schematisch anhand der Laserspots L11 bis L16 dargestellt.

In Figur 3 ist schematisch die Anordnung der sechs Laserdioden 31 bis 36 der Halbleiterlasereinrichtung 30 und der Umlenkprismen 37 bis 39 sowie der asphärischen Linsen 41 bis 46 dargestellt. Die von den Laserdioden 31 bis 36 erzeugten Laserlichtbündel 11 bis 16 sind in den Figuren 1 bis 5 durch mit Pfeilen versehene Linien 11 bis 16 dargestellt, welche die Ausbreitungsrichtungen der Laserlichtbündel 11 bis 16 zeigen. Die Fast-Axis FA der Laserlichtbündel 11 bis 16 ist in Figur 3 jeweils senkrecht zur Zeichenblattebene orientiert und ihre Slow-Axis SA liegt jeweils in der Zeichenblattebene.

Jeder Laserdiode 31 bis 36 ist eine asphärische optische Linse 41 bis 46 zugeordnet, die von den Laserlichtbündeln 11 bis 16 jeweils unmittelbar nach dem Verlassen der jeweiligen Laserdiode 31 bis 36 passiert wird. Die Brennweiten der asphärischen optischen Linsen 41 bis 46 sind derart gewählt, dass die Laserlichtbündel 11 bis 16 auf einer Oberfläche 90 des Lichtwellenlängenkonversionselements 9 jeweils einen Laserspot L11 bis L16 erzeugen, dessen Ausdehnung in horizontaler Richtung einen gewünschten Wert von beispielsweise jeweils 360 Mikrometer aufweisen.

Mit Hilfe von zwei Spiegelflächen des ersten Umlenkprismas 37, das zwischen der ersten 31 und zweiten Laserdiode 32 angeordnet ist, werden das erste 11 und zweite Laserlichtbündel 12 jeweils um einen Winkel von 90 Grad umgelenkt, so dass beide Laserlichtbündel 11, 12 jeweils parallel zum Boden 20 des Gehäuses 2 und in dieselbe Richtung verlaufen. Analog dazu werden mit Hilfe von zwei Spiegelflächen des zweiten Umlenkprismas 38, das zwischen der dritten 33 und vierten Laserdiode 34 angeordnet ist, das dritte 13 und vierte Laserlichtbündel 14 jeweils um einen Winkel von 90 Grad umgelenkt, so dass beide Laserlichtbündel 13, 14 jeweils parallel zum Boden 20 des Gehäuses 2 und in dieselbe Richtung verlaufen. Ebenso werden mit Hilfe von zwei Spiegelflächen des dritten Umlenkprismas 39, das zwischen der fünften 35 und sechsten Laserdiode 36 angeordnet ist, das fünfte 15 und sechste Laserlichtbündel 16 jeweils um einen Winkel von 90 Grad umgelenkt, so dass beide Laserlichtbündel 15, 16 jeweils parallel zum Boden 20 des Gehäuses 2 und in dieselbe Richtung verlaufen. Insgesamt verlaufen damit alle sechs Laserlichtbündel 11 bis 16 nach dem Verlassen des Beamcombiners 3 parallel zum Boden 20 und in dieselbe Richtung.

Am Ausgang des Beamcombiners 3 sind die sechs plankonkaven Zylinderlinsen 51 bis 56 angeordnet, die zur Aufweitung der Laserlichtbündel 11 bis 16 entlang ihrer Slow-Axis SA dienen und damit einer durch die asphärischen optischen Linsen 41 bis 46 verursachten Fokussierung der Laserlichtbündel 11 bis 16 entlang ihrer Slow-Axis SA entgegenwirken. Jedes der Laserlichtbündel 11 bis 16 durchläuft eine der stapelweise übereinander angeordneten plan-konkaven Zylinderlinsen 51 bis 56. Die plankonkaven Zylinderlinsen 51 bis 56 sind derart orientiert, dass ihre konkave Krümmung jeweils in Richtung bzw. entlang der Slow-Axis SA der Laserlichtbündel verläuft. Dadurch werden die Laserlichtbündel 11 bis 16 jeweils nur entlang ihrer Slow-Axis SA aufgeweitet. Die plan-konkaven Zylinderlinsen 51 bis 56 vergrößern nicht die Divergenz der Laserlichtbündel 11 bis 16 entlang der Fast-Axis FA. Die mittels der asphärischen optischen Linsen 41 bis 46 erreichte Fokussierung der Laserlichtbündel 11 bis 16 entlang ihrer Fast-Axis FA bleibt somit erhalten. Die drei plan-konkaven Zylinderlinsen 51, 53, 55 haben eine unterschiedliche Brennweite zu den anderen drei plankonkaven Zylinderlinsen 52, 54, 56, so dass die Laserlichtbündel 11, 13, 15 entlang ihrer Slow-Axis SA eine geringere Aufweitung erfahren als die Laserlichtbündel 12, 14, 16. Die Brennweiten der drei plan-konkaven Zylinderlinsen 51, 53, 55 sind derart auf die Brennweite der plan-konvexen Zylinderlinse 7 und auf die Brennweiten der asphärischen optischen Linsen 41, 43, 45 abgestimmt, dass die von den Laserlichtbündeln 11, 13, 15 auf der Oberfläche 90 des Lichtwellenlängenkonversionselements 9 verursachten Laserspots L11, L13, L15 in vertikaler Richtung eine gewünschte Ausdehnung mit einem Wert von beispielsweise jeweils 444 Mikrometer aufweisen.

Analog dazu sind die Brennweiten der drei plan-konkaven Zylinderlinsen 52, 54, 56 derart auf die Brennweite der plan-konvexen Zylinderlinse 7 und auf die Brennweiten der asphärischen optischen Linsen 42, 44, 46 abgestimmt, dass die von den Laserlichtbündeln 12, 14, 16 auf der Oberfläche 90 des Lichtwellenlängenkonversionselements 9 verursachten Laserspots L12, L14, L16 in vertikaler Richtung eine gewünschte Ausdehnung mit einem Wert von beispielsweise 756 Mikrometer aufweisen.

Nach dem Passieren der plan-konkaven Zylinderlinsen 51 bis 56 treffen die Laserlichtbündel 11 bis 16 auf den ersten Umlenkspiegel 61, der in der von der ersten 21 und zweiten Seitenwand 22 gebildeten Ecke angeordnet ist. Mit Hilfe des ersten Umlenkspiegels 61 werden die Laserlichtbündel 11 bis 16 jeweils um einen Winkel von 90 Grad umgelenkt, so dass sie in unterschiedlicher Höhe über dem Boden 20 und jeweils parallel zur zweiten Seitenwand 22 und zum Boden 20 verlaufen. Die Fast-Axis FA der Laserlichtbündel 11 bis 16 ist jeweils parallel zum Boden 20 orientiert und die Slow-Axis SA der Laserlichtbündel 11 bis 16 ist jeweils senkrecht zum Boden 20 angeordnet.

Mit Hilfe des zweiten Umlenkspiegels 62, der in der von der zweiten 22 und dritten Seitenwand 23 des Gehäuses 2 gebildeten Ecke angeordnet ist, werden die Laserlichtbündel 11 bis 16 um einen Winkel von 45 Grad umgelenkt, so dass sie nach dem Passieren der plan-konvexen Zylinderlinse 7 auf den mittig im Gehäuse 2 angeordneten Mikrospiegel 8 treffen. Die beiden Umlenkspiegel 61, 62 ermöglichen eine kompakte Anordnung der Komponenten der Beleuchtungseinrichtung 1 im Gehäuse 2.

Der Mikrospiegel 8 ist als MEMS Spiegel ausgebildet, wobei die Abkürzung MEMS für micro-electro-mechanical system steht. Die Abmessungen der Spiegelfläche des Mikrospiegels 8 betragen 5 mm mal 1,5 mm. Der Mikrospiegel 8 ist in einer Halterung 81 auf einem Sockel 82 am Boden 20 des Gehäuses 2 fixiert, so dass er um eine vertikal zum Boden 20 verlaufende Schwenkachse 80 schwenkbar ist. Mit Hilfe des Mikrospiegels 8 werden die Laserlichtbündel 11 bis 16 auf die Oberfläche 90 des Lichtwellenlängenkonversionselements 9 gelenkt. Durch eine Schwenkbewegung des Mikrospiegels 8 um seine Schwenkachse 80 wird ein Oberflächenabschnitt der Oberfläche 90 des Lichtwellenlängenkonversionselements 9 zeilenweise mit den Laserlichtbündeln 11 bis 16 abgetastet. Zur Abtastung oszilliert der Mikrospiegel 8 um seine Schwenkachse 80 mit einer Frequenz von beispielsweise 133 Hz. Der mit den Laserlichtbündeln 11 bis 16 beleuchtbare Oberflächenabschnitt der Oberfläche 90 des Lichtwellenlängenkonversionselements 9 ist durch den Schwenkbereich 17 des Mikrospiegels 8 begrenzt. In Figur 1 ist mittels gestrichelter Linien 17 der maximale Schwenkbereich schematisch dargestellt. Die Ansteuerung des Mikrospiegels 8 erfolgt elektromagnetisch. Dadurch kann der Mikrospiegel 8 anstelle einer Oszillationsbewegung auch statisch betrieben werden, um ihn beispielsweise in einer gewünschten Orientierung festzuhalten, oder es kann die Geschwindigkeit der Schwenkbewegung verändert werden oder die Schwenkbewegung nur über einen Teil des maximalen Schwenkbereichs ausgeführt werden. Der maximale Schwenkbereich kann kleiner oder größer sein als die lateralen Abmessungen des Lichtwellenlängenkonversionselements.

In Figur 6 ist die Anordnung der von den Laserlichtbündeln 11 bis 16 auf der Oberfläche 90 des Lichtwellenlängenkonversionselements erzeugten Laserspots L11 bis L16 entsprechend einer Momentaufnahme der Schwenkbewegung des Mikrospiegels 8 schematisch dargestellt. Die Laserspots L11 bis L16 sind auf der Oberfläche 90 des Lichtwellenlängenkonversionselements 9 vertikal übereinander angeordnet und werden durch die Schwenkbewegung des Mikrospiegels 8 um seine Schwenkachse 80 simultan entlang den mittels Doppelpfeil symbolisierten Abtastrichtungen 91 über die Oberfläche 90 geführt. Der Abstand zwischen den Laserspots L11 bis L16 auf der Oberfläche 90 des Lichtwellenlängenkonversionselements 9 wird mit Hilfe der plan-konvexen Zylinderlinse 7 auf einen gewünschten Wert eingestellt. Beispielsweise ist die Brennweite der plan-konvexen Zylinderlinse 7 derart gewählt, dass der Abstand zweier benachbarter Laserspots bei den Laserspots L11, L13 und L15 auf der Oberfläche 90 des Lichtwellenlängenkonversionselements 9 jeweils 600 Mikrometer beträgt und bei den Laserspots L12, L14 und L16 jeweils 900 Mikrometer beträgt.

Die Fast-Axis FA der Laserlichtbündel 11 bis 16 verläuft bei ihrem Auftreffen auf die Oberfläche 90 des Lichtwellenlängenkonversionselements 9 jeweils parallel zu den Abtastrichtungen 91 und ihre Slow-Axis verläuft jeweils senkrecht zu den Abtastrichtungen 91. In Figur 6 ist dieser Sachverhalt der Übersichtlichkeit halber nur für die von den Laserlichtbündeln 15, 16 verursachten Laserspot L15, L16 dargestellt. Die Laserspots L11, L13, L15 besitzen in Richtung der Slow-Axis SA jeweils eine maximale Abmessung von 444 Mikrometer und in Richtung der Fast-Axis FA jeweils eine maximale Abmessung von 360 Mikrometer. Die Laserspots L12, L14, L16 besitzen in Richtung der Slow-Axis SA jeweils eine maximale Abmessung von 756 Mikrometer und in Richtung der Fast-Axis FA jeweils eine maximale Abmessung von 360 Mikrometer. Die Kontur der Laserspots L11 bis L16 ist jeweils elliptisch, wobei durch die fokussierende bzw. aufweitende Wirkung der optischen Komponenten 41 bis 46, 51 bis 56 und 7 auf die Laserlichtbündel 11 bis 16 die große Halbachse der elliptischen Kontur jeweils parallel zur Slow-Axis SA und die kleine Halbachse der elliptischen Kontur jeweils parallel zur Fast-Axis FA und parallel zu den Abtastrichtungen 91 verläuft. In der schematischen Darstellung der Figur 6 ist die Wirkung der vorgenannten optischen Komponenten 41-46, 51-56, 7 auf die Form der Laserspots L11 bis L16 nicht berücksichtigt. Daher ist in der Darstellung der Figur 6 die große Halbachse der elliptischen Kontur der Laserspots L11 bis L16 jeweils parallel zur Fast-Axis und die kleine Halbachse der elliptischen Kontur der Laserspots L11 bis L16 jeweils parallel zur Slow-Axis orientiert.

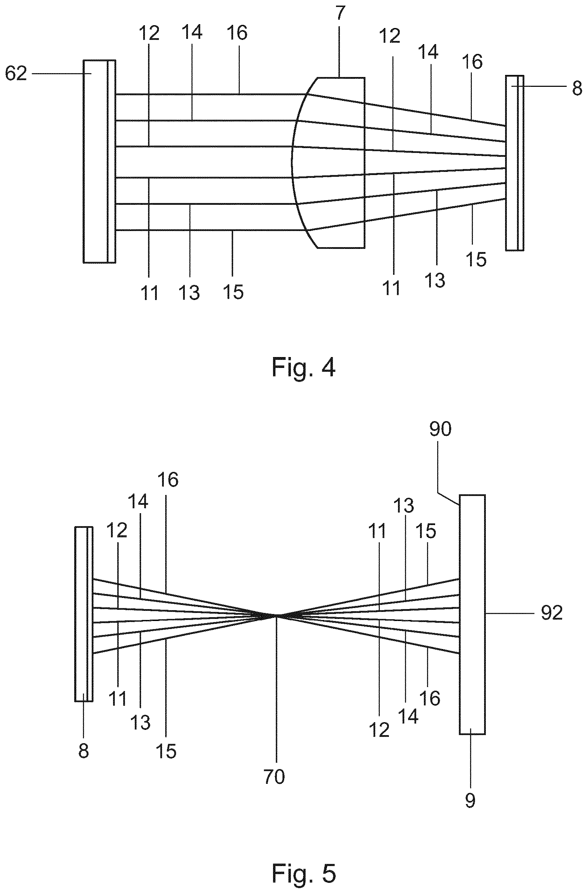

Figur 4 zeigt einen Querschnitt mit einer Schnittebene senkrecht zum Boden 20 durch den zweiten Umlenkspiegel 62, die plan-konvexe Zylinderlinse 7 und den Mikrospiegel 8. In Figur 4 ist der Verlauf der Laserlichtbündel 11 bis 16 zwischen dem zweiten Umlenkspiegel 62 und dem Mikrospiegel 8 schematisch dargestellt. Nach dem Umlenkspiegel 62 treffen alle Laserlichtbündel 11 bis 16 auf die plankonvexe Zylinderlinse 7. Mit Hilfe der plan-konvexen Zylinderlinse 7 wird die Slow-Axis SA der Laserlichtbündel 11 bis 16 auf der Oberfläche 90 des Lichtwellenlängenkonversionselements 9 justiert, so dass der vertikale Abstand zwischen den Laserspots L11 bis L16 auf einen gewünschten Wert eingestellt ist. Die Brennweite der plan-konvexen Zylinderlinse 7 ist daher entsprechend gewählt. Ihr Fokus 70 liegt im Bereich zwischen dem Mikrospiegel 8 und dem Lichtwellenlängenkonversionselement 9 (Fig. 5). Die konvexe Krümmung der plan-konvexen Zylinderlinse 7 ist parallel zur Slow-Axis SA der Laserlichtbündel 11 bis 16 orientiert. Daher entfaltet die plan-konvexe Zylinderlinse 7 ihre fokussierende Wirkung nur entlang der Slow-Axis SA der Laserlichtbündel 11 bis 16. In Figur 4 ist die Fast-Axis FA der Laserlichtbündel 11 bis 16 jeweils senkrecht zur Zeichenblattebene und die Slow-Axis jeweils in der Zeichenblattebene senkrecht zur Lichtausbreitungsrichtung orientiert.

Figur 5 zeigt einen Querschnitt mit einer Schnittebene senkrecht zum Boden 20 durch den Mikrospiegel 8 und das Lichtwellenlängenkonversionselement 9 in schematischer Darstellung. In Figur 5 ist der Verlauf der Laserlichtbündel 11 bis 16 zwischen dem Mikrospiegel 8 und der Oberfläche 90 des Lichtwellenlängenkonversionselements 9 schematisch dargestellt. Durch die Brechung der Laserlichtbündel 11 bis 16 an der plan-konvexen Zylinderlinse 7 und der Anordnung ihrer Brennlinie bzw. ihres linienförmigen Fokus 70 vor der Oberfläche 90 des Lichtwellenlängenkonversionselements 9 wird die Anordnung der Laserlichtbündel 11 bis 16 vertauscht, so dass der vom Laserlichtbündel 16 verursachte Laserspot L16 der unterste Laserspot und der vom Laserlichtbündel 15 verursachte Laserspot L15 der oberste Laserspot auf der Oberfläche 90 des Lichtwellenlängenkonversionselements 9 ist.

Das Lichtwellenlängenkonversionselement 9 ist in einem Fenster 230 in der dritten Seitenwand 23 des Gehäuses 2 der Beleuchtungseinrichtung 1 angeordnet. Das Lichtwellenlängenkonversionselement 9 besteht aus einem keramischen Leuchtstoff, der auf einem transparenten Substrat, das beispielsweise als rechteckige Saphirplatte ausgebildet ist, angeordnet ist. Als Leuchtstoff dient mit Cer dotiertes Yttriumaluminiumgranat (YAG:Ce). Die Abmessungen der Fensterfläche des Fensters 230 und des darin angeordneten Lichtwellenlängenkonversionselements 9 betragen nur wenige Quadratmillimeter, beispielsweise 20 mm².

Die Oberfläche 90 des Lichtwellenlängenkonversionselements 9 ist innerhalb des Gehäuses 2 und seine gegenüberliegende Oberfläche 92 ist außerhalb des Gehäuses 2 angeordnet. Das von den Laserlichtbündeln 11 bis 16 erzeugte und in den Laserspots L11 bis L16 auf die Oberfläche 90 auftreffende blaue Laserlicht durchdringt das Lichtwellenlängenkonversionselement 9 und wird dabei mittels des Leuchtstoffs anteilig in Licht anderer Wellenlänge mit einem Intensitätsmaximum im Wellenlängenbereich 560 von Nanometer bis 590 Nanometer konvertiert, so dass von der Oberfläche 92 des Lichtwellenlängenkonversionselements 9 weißes Licht abgestrahlt wird, das eine Mischung aus nicht-wellenlängenkonvertiertem blauem Laserlicht und vom Lichtwellenlängenkonversionselement 9 wellenlängenkonvertiertem Licht ist.

Insgesamt kann daher das im Fenster 230 angeordnete Lichtwellenlängenkonversionselement 9 bzw. seine an der Außenseite des Gehäuse 2 befindliche Oberfläche 92 als Lichtquelle angesehen werden, die weißes Licht mit hoher Intensität und Leuchtdichte emittiert.

Für die Anwendung in einem Kraftfahrzeugscheinwerfer kann die Oberfläche 92 des Lichtwellenlängenkonversionselements 9 mittels einer Sekundäroptik, beispielsweise mittels einer Projektionsoptik, auf die Fahrbahn vor dem Fahrzeug projiziert werden, um eine gewünschte Lichtverteilung, beispielsweise für Abblendlicht oder Fernlicht, zu erzeugen. Die gewünschte Lichtverteilung wird mit Hilfe der Laserspots L11 bis L16 auf der Oberfläche 90 des Lichtwellenlängenkonversionselements 9 generiert. Die Laserspots L11 bis L16 werden durch die Schwenkbewegung des Mikrospiegels 8 über einen Oberflächenabschnitt der Oberfläche 90 des Lichtwellenlängenkonversionselements 9 geführt. Während der Schwenkbewegung des Mikrospiegels 8 können beispielsweise einzelne Laserdioden 31 bis 36 zeitweilig ausgeschaltet oder gedimmt oder strommäßig überhöht betrieben werden, so dass einzelne Laserspots L11 bis L16 zeitweise in ihrer Intensität verändert und/oder moduliert sind, oder der Schwenkbereich des Mikrospiegels 8 kann eingeschränkt werden, um die Lichtverteilung zu verändern.

Die Beleuchtungseinrichtung 1 ist Bestandteil eines Kraftfahrzeugscheinwerfers. Die beiden einander gegenüberliegenden Seitenwände 22, 24 des Gehäuses 2 sind an ihrer Außenseite jeweils mit einer Befestigungsvorrichtung 220 240 versehen, die eine Montage der Beleuchtungseinrichtung 1 in einem Kraftfahrzeugscheinwerfer ermöglicht.

Die Erfindung beschränkt sich nicht auf das oben näher erläuterte Ausführungsbeispiel der Erfindung.

Beispielsweise kann anstelle von sechs Laserdioden 31 bis 36 eine geringere oder eine höhere Anzahl von Laserdioden verwendet werden. Außerdem können die optischen Komponenten 41 bis 46, 51 bis 56 und 7 derart ausgebildet sein, dass die Abmessungen der Laserspots L11 bis L16 in Richtung der Slow-Axis und Fast-Axis andere Werte aufweisen als bei dem oben erläuterten Ausführungsbeispiel der Erfindung. Insbesondere können einige oder alle Laserspots L11 bis L16 auf der Oberfläche 90 des Lichtwellenlängenkonversionselements 9 auch überlappend oder mit unterschiedlichen Abständen angeordnet sein.

Ferner kann die Beleuchtungseinrichtung 1 mehrere Lichtwellenlängenkonversionselement 9 aufweisen, deren Oberfläche mit Hilfe des Mikrospiegels 8 mit Laserlicht abgetastet wird. Es können weiterhin mehrere Mikrospiegel 8 vorgesehen sein. Um einen Oberflächenabschnitt der Oberfläche eines oder mehrerer Lichtwellenlängenkonversionselemente 9 mit Laserlicht abzutasten.

Das Lichtwellenlängenkonversionselement 9 kann ferner als um seine Achse drehbar gelagertes Leuchtstoffrad ausgebildet sein. Durch eine Rotation des Leuchtstoffrades wird die Beleuchtungsdauer der mit Leuchtstoff beschichteten Bereiche reduziert und damit die Wärmeabfuhr verbessert. Das Leuchtstoffrad kann außerdem Segmente mit unterschiedlicher Leuchtstoffbeschichtung aufweisen, um beispielsweise weißes Licht mit unterschiedlicher Farbtemperatur zu erzeugen.

In einer weiteren Ausgestaltung (ohne Abbildung) kann die Halbleiterlaseranordnung sowie die Strahlführungs- und Strahlformungsanordnung verdoppelt und symmetrisch zur ersten Bestrahlungsanordnung angeordnet sein und somit ermöglichen, dass die zusätzlichen Hableiterlaser von der gegenüberliegenden Seite auf den Mikrospiegel bzw. das Lichtwellenlängenkonversionselement einstrahlen. Durch die dann mögliche Doppelbestrahlung des Lichtwellenlängenkonversionselement kann die Lichterzeugungsleistung der Beleuchtungseinrichtung erhöht werden. Dabei muss die zweite Bestrahlungsanordnung nicht die gesamte Fläche des Lichtwellenlängenkonversionselementes überstreichen, sondern kann dies auch nur abschnittsweise tun. Dadurch kann zum Beispiel besonders die Lichterzeugung im Zentrumsbereich des Lichtwellenlängenkonversionselement erhöht werden. Die Erhöhung der Lichterzeugung durch die doppelte Bestrahlungsführung kann aber auf alle Bereiche des Lichtwellenlängenkonversionselement angewendet werden. Die zweite Bestrahlungsanordnung kann höhenversetzt zur ersten Bestrahlungsanordnung sein. Dadurch lässt sich das Lichtwellenlängenkonversionselement mit enger liegenden Bestrahlungsbahnen überstreichen, was zu einer höheren Auflösung der zu erzeugenden Lichtverteilungen (Fernlicht, Abblendlicht, etc.) führt.

Auch kann die Wellenlänge der Halbleiterlaser der zweiten Bestrahlungsanordnung unterschiedlich zu der der ersten Bestrahlungsanordnung sein.

Anstelle eines MEMS-Spiegels könnte auch eine schwenkbare LCoS (Liquid-Crystal-on-Silicon) Spiegelanordnung verwendet werden.

### BEZUGSZEICHENLISTE

- 1: Beleuchtungseinrichtung
- 11 bis 16: Laserlichtbündel
- 2: Gehäuse
- 20: Boden
- 21: erste Seitenwand
- 22: zweite Seitenwand
- 23: dritte Seitenwand
- 24: vierte Seitenwand
- 220, 240: Befestigungsmittel
- 3: Halbleiterlasereinrichtung
- 31 bis 36: Laserdioden
- 37 bis 39: Umlenkprismen
- 41 bis 46: asphärischen optische Linsen
- 51 bis 56: plan-konkave Zylinderlinsen
- 61, 62: Umlenkspiegel
- 7: plan-konvexe Zylinderlinse
- 70: Brennlinie der plan-konvexen Zylinderlinse 7
- 8: schwenkbarer Mikrospiegel
- 80: Schwenkachse des Mikrospiegels
- 81: Halterung des Mikrospiegels
- 82: Sockel des Mikrospiegels
- 9: Lichtwellenlängenkonversionselement
- 90: innen liegende Oberfläche des Lichtwellenlängenkonversionselements
- 92: außen liegende Oberfläche des Lichtwellenlängenkonversionselements
- 91: Abtastrichtungen
- L11 bis L16: Laserspots
- L1 bis L3: Laserspots
- E1 bis E3: fiktive Ebenen
- FA: Fast-Axis der Laserlichtbündel
- SA: Slow-Axis der Laserlichtbündel

## Patentansprüche

1. Beleuchtungsvorrichtung (1) mit einer Halbleiterlasereinrichtung (30), die ausgebildet ist, mehrere Laserlichtbündel (11 bis 16) zu erzeugen, und mit mindestens einem Lichtwellenlängenkonversionselement (9), das ausgebildet ist, Licht der Laserlichtbündel (11 bis 16) zumindest anteilig in Licht anderer Wellenlänge zu konvertieren, sowie mit einer Optik, die ausgebildet ist, die Laserlichtbündel (11 bis 16) auf eine Oberfläche (90) des mindestens einen Lichtwellenlängenkonversionselement (9) zu lenken, wobei die Optik mindestens ein um mindestens eine Achse (80) schwenkbares Spiegelelement (8) aufweist, das ausgebildet ist, die Laserlichtbündel (11 bis 16) über zumindest einen Oberflächenabschnitt der Oberfläche (90) des mindestens einen Lichtwellenlängenkonversionselements (9) zu führen, und wobei die Optik Mittel (7, 41 bis 46, 51 bis 56) zur Justierung einer Divergenz bzw. Aufweitung der Laserlichtbündel (11 bis 16) entlang einer Slow-Axis (SA) oder bzw. und einer Fast-Axis (FA) der Laserlichtbündel (11 bis 16) auf dem Oberflächenabschnitt der Oberfläche (90) des mindestens einen Lichtwellenlängenkonversionselements (9) umfasst, **dadurch gekennzeichnet, dass** die Mittel mindestens ein asphärisches optisches Element (41 bis 46) zur Fokussierung der Laserlichtbündel (11 bis 16) entlang der Fast-Axis (FA) der Laserlichtbündel (11 bis 16) und mindestens eine plan-konkave Zylinderlinse (51 bis 56) umfassen, die zwecks Aufweitung der Laserlichtbündel (11 bis 16) entlang der Slow-Axis (SA) zumindest eines Laserlichtbündels (11 bis 16) im Lichtstrahlengang zumindest eines Laserlichtbündels (11 bis 16) angeordnet ist und damit einer durch das mindestens eine asphärische optische Element (41 bis 46) bewirkten Fokussierung der Laserlichtbündel (11 bis 16) entlang der Slow-Axis entgegenwirkt .

2. Beleuchtungsvorrichtung (1) nach Anspruch 1, wobei die Mittel zudem mindestens eine erste Zylinderlinse (7) zur Fokussierung der Laserlichtbündel (11 bis 16) entlang der Slow-Axis (SA) der Laserlichtbündel (11 bis 16) umfassen.

3. Beleuchtungsvorrichtung (1) nach Anspruch 2, wobei die mindestens eine erste Zylinderlinse (7) als plankonvexe Zylinderlinse ausgebildet ist, deren konvexe Krümmung in Richtung der Slow-Axis (SA) der Laserlichtbündel (11 bis 16) verläuft.

4. Beleuchtungsvorrichtung (1) nach einem der Ansprüche 1 bis 3, wobei die Optik und die Halbleiterlasereinrichtung (30) derart ausgebildet sind, dass die Laserlichtbündel (11 bis 16) jeweils parallel zu einer Abtastrichtung (91) über den Oberflächenabschnitt der Oberfläche (90) des mindestens einen Lichtwellenlängenkonversionselements (9) geführt werden.

5. Beleuchtungsvorrichtung (1) nach Anspruch 4, wobei die Optik und die Halbleiterlasereinrichtung (30) derart ausgebildet sind, dass die Slow-Axis (SA) der Laserlichtbündel (11 bis 16) auf dem Oberflächenabschnitt der Oberfläche (90) des mindestens einen Lichtwellenlängenkonversionselements (9) jeweils senkrecht zur Abtastrichtung (91) angeordnet ist.

6. Beleuchtungsvorrichtung (1) nach Anspruch 1, wobei die konkave Krümmung der mindestens einen plankonkaven Zylinderlinse (51 bis 56) in Richtung der Slow-Axis (SA) des Laserlichtbündels (11 bis 16) verläuft.

7. Beleuchtungsvorrichtung (1) nach Anspruch 1, wobei die Mittel, zwecks Aufweitung mehrerer Laserlichtbündel (11 bis 16) entlang ihrer Slow-Axis (SA), mehrere plan-konkave Zylinderlinsen (51 bis 56) mit unterschiedlichen optischen Eigenschaften umfassen.

8. Beleuchtungsvorrichtung (1) nach Anspruch 1, wobei die Beleuchtungseinrichtung derart ausgebildet ist, dass die Ausbreitungsrichtung (110) und die Slow-Axis (SA) sowie die Fast-Axis (FA) der von der Halbleiterlasereinrichtung (30) emittierten Laserlichtbündel (11 bis 16) jeweils parallel zueinander ausgerichtet sind.

9. Beleuchtungsvorrichtung (1) nach einem der Ansprüche 1 bis 8, wobei die Halbleiterlasereinrichtung (30) mehrere Laserdioden (31 bis 36) aufweist, die jeweils ausgebildet sind, während des Betriebs blaues Laserlicht zu erzeugen, und wobei das mindestens eine Lichtwellenlängenkonversionselement (9) derart ausgebildet ist, blaues Laserlicht anteilig in Licht anderer Wellenlänge zu konvertieren, so dass von dem mindestens einen Lichtwellenlängenkonversionselement (9) weißes Licht emittiert wird, das eine Mischung aus nicht-wellenlängenkonvertiertem blauem Laserlicht und am mindestens einen Lichtwellenlängenkonversionselement (9) wellenlängenkonvertiertem Licht ist.

## Claims

1. Illumination apparatus (1) having a semiconductor laser device (30) that is configured to generate a plurality of laser beams (11 to 16), and having at least one light wavelength conversion element (9) that is configured to convert at least a portion of the light of the laser beams (11 to 16) into light having a different wavelength, and having an optical unit that is configured to direct the laser beams (11 to 16) onto a surface (90) of the at least one light wavelength conversion element (9), wherein the optical unit has at least one mirror element (8) that is able to be pivoted about at least one axis (80) and is configured to guide the laser beams (11 to 16) over at least one surface section of the surface (90) of the at least one light wavelength conversion element (9), and wherein the optical unit comprises means (7, 41 to 46, 51 to 56) for adjusting a divergence or expansion of the laser beams (11 to 16) along a slow axis (SA) or/and a fast axis (FA) of the laser beams (11 to 16) on the surface section of the surface (90) of the at least one light wavelength conversion element (9), **characterized in that** the means comprise at least one aspherical optical element (41 to 46) for focusing the laser beams (11 to 16) along the fast axis (FA) of the laser beams (11 to 16) and at least one plano-concave cylindrical lens (51 to 56) that is arranged in the light beam path of at least one laser beam (11 to 16) for the purpose of expanding the laser beams (11 to 16) along the slow axis (SA) of at least one laser beam (11 to 16) and thus counteracts a focusing of the laser beams (11 to 16) along the slow axis caused by the at least one aspherical optical element (41 to 46).

2. Illumination apparatus (1) according to Claim 1, wherein the means additionally comprise at least one first cylindrical lens (7) for focusing the laser beams (11 to 16) along the slow axis (SA) of the laser beams (11 to 16).

3. Illumination apparatus (1) according to Claim 2, wherein the at least one first cylindrical lens (7) is configured in the form of a plano-convex cylindrical lens, the convex curvature of which extends in the direction of the slow axis (SA) of the laser beams (11 to 16).

4. Illumination apparatus (1) according to one of Claims 1 to 3, wherein the optical unit and the semiconductor laser device (30) are configured such that the laser beams (11 to 16) are each guided parallel with respect to a scanning direction (91) over the surface section of the surface (90) of the at least one light wavelength conversion element (9).

5. Illumination apparatus (1) according to Claim 4, wherein the optical unit and the semiconductor laser device (30) are configured such that the slow axis (SA) of the laser beams (11 to 16) is arranged on the surface section of the surface (90) of the at least one light wavelength conversion element (9) in each case perpendicular to the scanning direction (91).

6. Illumination apparatus (1) according to Claim 1, wherein the concave curvature of the at least one plano-concave cylindrical lens (51 to 56) extends in the direction of the slow axis (SA) of the laser beam (11 to 16).

7. Illumination apparatus (1) according to Claim 1, wherein the beams comprise a plurality of plano-concave cylindrical lenses (51 to 56) with differing optical properties for the purpose of expanding a plurality of laser beams (11 to 16) along their slow axis (SA).

8. Illumination apparatus (1) according to Claim 1, wherein the illumination device is configured such that the propagation direction (110) and the slow axis (SA) and the fast axis (FA) of the laser beams (11 to 16), which are emitted by the semiconductor laser device (30), are aligned in each case parallel with respect to one another.

9. Illumination apparatus (1) according to one of Claims 1 to 8, wherein the semiconductor laser device (30) has a plurality of laser diodes (31 to 36), which are each configured to generate blue laser light during operation, and wherein the at least one light wavelength conversion element (9) is configured to convert a portion of the blue laser light into light of a different wavelength, with the result that the at least one light wavelength conversion element (9) emits white light which is a mixture of non-wavelength-converted blue laser light and light that has been wavelength-converted at the at least one light wavelength conversion element (9).

## Revendications

1. Dispositif d'éclairage (1) avec un dispositif laser semi-conducteur (30), qui est conçu pour produire plusieurs faisceaux laser (11 à 16) et avec au moins un élément de conversion de longueurs d'onde (9) qui est conçu pour convertir la lumière des faisceaux laser (11 à 16) au moins en partie en lumière d'une autre longueur d'onde, ainsi qu'avec une optique qui est conçue pour dévier les faisceaux laser (11 à 16) vers une surface (90) de l'au moins un élément de conversion de longueurs d'onde (9), dans lequel l'optique comprend au moins un élément de miroir (8) pivotant autour d'au moins un axe (80), qui est conçu pour guider les faisceaux laser (11 à 16) sur au moins une portion de surface de la surface (90) de l'au moins un élément de conversion de longueurs d'onde (9) et dans lequel l'optique comprend des moyens (7, 41 à 46, 51 à 56) pour l'ajustement d'une divergence respectivement d'un élargissement des faisceaux laser (11 à 16) le long d'un axe Lent (SA) ou respectivement et d'un axe Rapide (FA) des faisceaux laser (11 à 16) sur la portion de surface de la surface (90) de l'au moins un élément de conversion de longueurs d'onde (9), **caractérisé en ce que** les moyens comprennent au moins un élément optique asphérique (41 à 46) pour la focalisation des faisceaux laser (11 à 16) le long de l'axe Rapide (FA) des faisceaux laser (11 à 16) et au moins une lentille cylindrique plan-concave (51 à 56) qui est disposée, pour l'élargissement des faisceaux laser (11 à 16), le long de l'axe Lent (SA) d'au moins un faisceau laser (11 à 16) dans le trajet des rayons lumineux d'au moins un faisceau laser (11 à 16) et agit donc contre une focalisation des faisceaux laser (11 à 16) le long de l'axe Lent provoquée par l'au moins un élément optique asphérique (41 à 46).

2. Dispositif d'éclairage (1) selon la revendication 1, dans lequel les moyens comprennent en outre au moins une première lentille cylindrique (7) pour la focalisation des faisceaux laser (11 à 16) le long de l'axe Lent (SA) des faisceaux laser (11 à 16).

3. Dispositif d'éclairage (1) selon la revendication 2, dans lequel l'au moins une première lentille cylindrique (7) est conçue comme une lentille cylindrique plan-convexe dont la courbure convexe s'étend en direction de l'axe Lent (SA) des faisceaux laser (11 à 16).

4. Dispositif d'éclairage (1) selon l'une des revendications 1 à 3, dans lequel l'optique et le dispositif laser semi-conducteur (30) sont conçus de façon à ce que les faisceaux laser (11 à 16) soient guidés chacun parallèlement à une direction de balayage (91) sur la portion de surface de la surface (90) de l'au moins un élément de conversion de longueurs d'onde (9).

5. Dispositif d'éclairage (1) selon la revendication 4, dans lequel l'optique et le dispositif laser semi-conducteur (30) sont conçus de façon à ce que l'axe Lent (SA) des faisceaux laser (11 à 16) soit disposé sur la portion de surface de la surface (90) de l'au moins un élément de conversion de longueurs d'onde (9), perpendiculairement à la direction de balayage (91).

6. Dispositif d'éclairage (1) selon la revendication 1, dans lequel la courbure concave de l'au moins une lentille cylindrique plan-concave (51 à 56) en direction de l'axe Lent (SA) du faisceau laser (11 à 16).

7. Dispositif d'éclairage (1) selon la revendication 1, dans lequel les moyens comprennent, pour l'élargissement de plusieurs faisceaux laser (11 à 16) le long de leur axe Lent (SA), plusieurs lentilles cylindriques plan-concaves (51 à 56) avec différentes propriétés optiques.

8. Dispositif d'éclairage (1) selon la revendication 1, dans lequel le dispositif d'éclairage est conçu de façon à ce que la direction de propagation (110) et l'axe Lent (SA) ainsi que l'axe Rapide (FA) des faisceaux laser (11 à 16) émis par le dispositif laser semi-conducteur (30) soient orientés parallèlement entre eux.

9. Dispositif d'éclairage (1) selon l'une des revendications 1 à 8, dans lequel le dispositif laser semi-conducteur (30) comprend plusieurs diodes laser (31 à 36) qui sont respectivement conçues pour produire, pendant le fonctionnement, une lumière laser bleue et dans lequel l'au moins un élément de conversion de longueurs d'onde (9) est conçu de façon à convertir la lumière laser bleue en une lumière d'une autre longueur d'onde, de façon à ce qu'une lumière blanche soit émise par l'au moins un élément de conversion de longueurs d'onde (9), qui est un mélange d'une lumière laser bleue dont la longueur d'onde n'est pas convertie et d'une lumière dont la longueur d'onde a été convertie dans l'au moins un élément de conversion de longueurs d'onde (9).
